(19) Europäisches Patentamt
European Patent Office
Office européen des brevets

(11) **EP 3 301 812 A1**

(12) **EUROPÄISCHE PATENTANMELDUNG**

(43) Veröffentlichungstag:
**04.04.2018 Patentblatt 2018/14**

(51) Int Cl.:
***H03M 1/56*** *(2006.01)*

(21) Anmeldenummer: **17191749.5**

(22) Anmeldetag: **19.09.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(30) Priorität: **23.09.2016 DE 102016117977**

(71) Anmelder: **Sensus Spectrum LLC
Raleigh NC 27615 (US)**

(72) Erfinder: **SCHÄFER, Burghard
67112 Mutterstadt (DE)**

(74) Vertreter: **Patentanwälte Dr. Keller, Schwertfeger
Westring 17
76829 Landau (DE)**

(54) **VORRICHTUNG UND VERFAHREN ZUR DIGITALISIERUNG VON ANALOGEN MESSWERTEN**

(57)     Die Erfindung betrifft eine Vorrichtung sowie ein Verfahren zur Digitalisierung von wenigstens einem analogen Messwert, umfassend eine Messschaltung (12) mit einem Messelement (RM_V, RM_R), einem ersten Referenzelement (R_Bas) und einem zweiten Referenzelement (R_Ref), die in Serie angeordnet sind, wobei die Messschaltung (12) wenigstens drei Ausgänge (14) aufweist, an denen analoge Ausgangsinformationen in Form von Ausgangspotentialen abgegriffen werden können, einen Multiplexer (16), der einzeln und nacheinander mit den wenigstens drei Ausgängen (14) verbindbar ist, einen Spannungsrampengenerator (18), ein erstes Vergleichselement (24), das an seinem ersten Eingang unter Zwischenschaltung des Multiplexers (16) mit der Messschaltung (12) und an seinem zweiten Eingang mit dem Spannungsrampengenerator (18) verbunden ist, eine Zählvorrichtung mit wenigstens zwei Zählern, eine Steuervorrichtung und eine Recheneinheit.

Fig 1

EP 3 301 812 A1

**Beschreibung**

Die vorliegende Erfindung betrifft eine Vorrichtung zur Digitalisierung von wenigstens einem analogen Messwert sowie ein Verfahren zur Digitalisierung von wenigstens einem analogen Messwert. Insbesondere betrifft die Erfindung eine Vorrichtung und ein Verfahren zur Digitalisierung von wenigstens einem analogen Messwert, welche zur Temperaturbestimmung, insbesondere zur Bestimmung einer Temperaturdifferenz beispielsweise in Wärmezählern geeignet sind.

Wärmezähler dienen zur Ermittlung der Wärmeenergie und ermitteln die Wärmeenergie aus einem Volumenstrom eines zirkulierenden Mediums in einem Heizkreislauf sowie der Temperaturdifferenz des Mediums zwischen Vor- und Rücklauf. Bei solchen Wärmezählern werden zur Bestimmung der Temperatur üblicherweise Messwiderstände eingesetzt.

Da üblicherweise die von den Wärmezählern ermittelten Werte digital gespeichert und verarbeitet werden, besteht die Notwendigkeit, die analogen Signale der Messwiderstände in digitale Signale umzuwandeln.

Bei bisher bekannten Wärmezählern werden die von den Messwiderständen erfassten Werte mit Analog-Digital-Wandlern verarbeitet, die nach dem Delta-Sigma Prinzip arbeiten. Analog-Digital Wandler umfassen einen Delta-Sigma-Modulator, der einen sogenannten "Bitstream" erzeugt, und einen Tiefpassfilter.

Die Analog-Digital-Wandler nach dem Delta-Sigma Prinzip sind üblicherweise kontinuierlich eingeschaltet, um eine hohe Messgenauigkeit zu erreichen. Der Nachteil von Delta-Sigma-Analog-Digital-Wandlern ist daher deren recht hoher Stromverbrauch.

Weiterhin werden Wärmezähler mit Analog-Digital-Wandlern verwendet, die nach dem Prinzip der sukzessiven Approximation arbeiten. Bei Analog-Digital-Wandlern, die nach dem Prinzip der sukzessiven Approximation arbeiten, werden in einem Datenspeicher zunächst alle Bits auf Null gesetzt. Beginnend mit dem höchstwertigen Bit (Most Significant Bit, MSB) werden abwärts bis zum niederwertigsten Bit (Least Significant Bit, LSB) nacheinander alle Bits des Digitalwerts ermittelt. Analog-Digital-Wandler, die auf Basis der sukzessiven Approximation arbeiten, sind vergleichsweise schnell, haben jedoch Grenzen hinsichtlich der Messgenauigkeit und der Messstabilität.

Neben den beiden bereits genannten Arten eines Analog-Digital-Wandlers gibt es darüber hinaus integrierende Analog-Digital-Wandler. Bei den integrierenden Analog-Digital-Wandlern wird eine unbekannte Eingangsspannung in eine zeitliche Periode umgewandelt. Während dieser Periode werden dann Taktimpulse von einem Zähler ausgewertet. Im Wesentlichen unterscheidet man hier das sogenannte Single-Slope-Prinzip und das Dual Slope-Prinzip.

Bei dem Single-Slope-Verfahren wird die Integration nur über eine Spannungsrampe ausgeführt. Dazu wird ein Generator verwendet, der eine präzise Sägezahnspannung bzw. Spannungsrampe erzeugt und diese auf einen oberen und einen unteren Komparator gibt. Der obere Komparator vergleicht die Sägezahnspannung mit der Masse, der untere Komparator dagegen mit der Messspannung. Der obere Komparator startet einen Zählzyklus, wenn die Rampenspannung die Nullspannungslinie durchläuft, während der untere Komparator den Zählzyklus stoppt, wenn die Rampenspannung den Wert der Messspannung erreicht hat. Zum Ende des Zählvorgangs wird das Zählergebnis des Zählzyklus in ein Register übertragen und steht als digitales Signal zur Verfügung. Anschließend wird der Zähler zurückgesetzt und ein neuer Umsetzungsvorgang beginnt. Die Zeit des Zählzyklus ist proportional zur analogen Messspannung.

Die Umsetzungszeit bei diesem Analog-Digital-Wandler ist abhängig von der Eingangsspannung. Schnell veränderliche Signale können mit dieser Art von Analog-Digital-Wandlern nicht erfasst werden. Weiterhin ist es bei dieser Art von Analog-Wandlung nur schwierig möglich, aus zwei verschiedenen digitalisierten Daten Differenzwerte zu bestimmen, da Betriebs-und Driftschwankungen vorhanden sind.

Bei einer Weiterentwicklung nach dem Dual-Slope-Verfahren wird zunächst ein Integratoreingang eines Integrators mit einer unbekannten Analog-Digital-Wandler-Eingangsspannung verbunden und es erfolgt die Ladung über ein fest vorgegebenes Zeitintervall. Für die anschließende Entladung wird der Integrator mit einer bekannten Referenzspannung entgegengesetzter Polarität verbunden. Die benötigte Entladezeit bis zum Erreichen der Spannung Null am Integratorausgang wird durch einen Zähler ermittelt. Der Zählerstand steht bei geeigneter Dimensionierung unmittelbar für die Eingangsspannung. Diese Art von Analog-Digital-Wandlern hat den Vorteil einer hohen Auflösung und einer guten Unterdrückung von Störsignalen wie Rauschen oder Netzeinkopplung. Jedoch sind diese Analog-Digital-Wandler eher langsam.

Sowohl in der EP 1 630 533 B1 als auch in der DE 32 00 353 A1 werden Temperaturmessvorrichtungen beschrieben, bei denen ein integrierender Analog-Digital-Wandler eingesetzt wird.

Nachteilig an der in Dokument EP 1 630 533 B1 beschriebenen Vorrichtung bzw. an dem damit durchgeführten Verfahren ist der hohe Stromverbrauch der Vorrichtung bei Dauerbetrieb. Um die Schaltung in einem Wärmezähler kostengünstig mit einer Batterie zu betreiben, dürfte die Strom- bzw. Spannungsversorgung nur während der eigentlichen Messzeit eingeschaltet und danach wieder ausgeschaltet werden. Im Falle des wechselweise Ein- und Ausschaltens treten jedoch Störungen in der Versorgungsquelle der Messvorrichtung auf, die wiederum bei den nachgeschalteten Elementen der Schaltung zu Ungenauigkeiten führen. Insbesondere wirken sich diese Störungen in der Versorgungsquelle auf den Verlauf einer Rampenspannung aus. Bei der Weiterverarbeitung der mittels der Schaltung erhaltenen Digitaldaten wie etwa der Differenzbestimmung zweier digitaler Werte in einem Wärmezähler, führt dies zu einer vergleichsweise hohen Streubreite der verarbeiteten Daten.

In ähnlicher Weise wie die EP 1 630 533 B1 zeigt die DE 32 00 353 A1 den Nachteil eines vergleichsweise hohen Stromverbrauchs im Dauerbetrieb. Ebenso verursachen Schwankungen in der Versorgungsquelle, beispielsweise aufgrund von Ein- und Ausschaltvorgängen Schwankungen einer Integrationsrampe, was wiederum zu einer vergleichsweisen hohen Streubreite bei der Bestimmung von Differenzwerten, wie etwa bei der Bestimmung der Temperaturdifferenz in einem Wärmezähler, führt.

Es ist daher Aufgabe der vorliegenden Erfindung, eine Vorrichtung und ein Verfahren zur Digitalisierung von wenigstens einem analogen Messwert bereitzustellen, welche es ermöglichen, die Messgenauigkeit und Messstabilität von Messwiderständen zu verbessern, insbesondere die Messgenauigkeit und die Messstabilität in Wärmezählern zu verbessern und welche geringe Betriebskosten, insbesondere einen niedrigen Stromverbrauch aufweisen.

Erfindungsgemäß wird die Aufgabe gelöst durch eine Vorrichtung zur Digitalisierung von wenigstens einem analogen Messwert umfassend eine Messschaltung mit einem Messelement, einem ersten Referenzelement und einem zweiten Referenzelement, die in Serie angeordnet sind, wobei die Messschaltung wenigstens drei Ausgänge aufweist, an denen analoge Ausgangsinformationen in Form von Ausgangspotentialen abgegriffen werden können, einen Multiplexer, der einzeln und nacheinander mit den wenigstens drei Ausgängen verbindbar ist, einen Spannungsrampengenerator, ein erstes Vergleichselement, das an seinem ersten Eingang unter Zwischenschaltung des Multiplexers mit der Messschaltung und an seinem zweiten Eingang mit dem Spannungsrampengenerator verbunden ist, eine Zählvorrichtung mit wenigstens zwei Zählern, eine Steuervorrichtung und eine Recheneinheit, wobei die Vorrichtung zur Digitalisierung eines analogen Messwerts ausgelegt ist, die Umsetzung des analogen Messwert in einen digitalen Messwert mittels zweier nacheinander ablaufender Diskretisierungsschritte durchzuführen, wobei in jedem Diskretisierungsschritt ein erstes Referenzpotential mittels einer ersten Ausgangsinformation und ein zweites Referenzpotential mittels einer anderen als der ersten Ausgangsinformation bestimmt wird, wobei in beiden Diskretisierungsschritten das erste Referenzpotential auf derselben Ausgangsinformation und das zweite Referenzpotential auf unterschiedlichen Ausgangsinformationen basiert, und wobei die Zählvorrichtung geeignet ist, in jedem Diskretisierungsschritt einer Differenz gebildet aus dem ersten Referenzpotential und dem zweiten Referenzpotential einen Zählwert zuzuordnen.

Unter Diskretisierungsvorgang wird der Vorgang beschrieben, bei dem einem analogen Wert ein digitalisierbarer Wert zugeordnet wird.

Mit Hilfe dieser Vorrichtung lassen sich analoge Messwerte schnell und kostengünstig in zuverlässige Digitalwerte umwandeln.

Bei einer bevorzugten Ausführungsform sind das Messelement und das zweite Referenzelement in Stromflussrichtung der Messschaltung vor dem ersten Referenzelement angeordnet und die wenigstens drei Ausgänge der Messschaltung befinden sich in Stromflussrichtung der Messschaltung vor und hinter dem Messelement und vor und hinter dem zweiten Referenzelement.

Auf diese Weise lässt sich der am Messelement anliegende analoge Messwert einfach digital bestimmen.

Bei einer vorteilhaften Weiterbildung der Vorrichtung ist ein Impedanzwandler vorgesehen, wobei der Impedanzwandler zwischen dem Ausgang des Multiplexers und dem ersten Eingang des ersten Vergleichselements angeordnet ist. Der Impedanzwandler weist beispielsweise die Form eines Operationsverstärkers auf und wirkt als Spannungsfolger. Auf diese Weise werden die Strombelastung der Ausgangspotentiale und damit verursachte Messfehler minimiert.

Um sicherzustellen, dass auch bei Schwankungen des Referenzpotentials die Spannungsrampe des Spannungsrampengenerators zu Beginn des Zählvorgangs durch das Referenzpotential hindurchgeht, ist bei einer bevorzugten Weiterbildung ein Zeitzählelement vorgesehen.

Das Zeitzählelement gibt eine Zeit vor, in der die Spannung der vom Spannungsrampengenerator erzeugten Spannungsrampe beim Löschungsvorgang bewusst mit dem entgegengesetzten Vorzeichen, das für den Messvorgang erforderlich ist, nach Durchgang durch das Referenzpotential von dem Referenzpotential weggeführt wird. Vorzugsweise ist die vom Zeitzählelement vorgegebene Zeit so lange, dass die Spannung der Rampenspannung nach Ablauf der vom Zeitzählelement vorgegebenen Zählzeit einen Wert außerhalb der Schwankungsbreite der Referenzspannung erreicht.

Die Bezeichnung Vorzeichen bezieht sich auf die Steigung der Spannungsrampe. Ein negatives Vorzeichen bedeutet eine fallende Spannungsrampe, während ein positives Vorzeichen für eine steigende Spannungsrampe steht.

Es ist weiter bevorzugt, dass das Messelement und das Referenzelement jeweils ein Messwiderstand ist, um Temperaturmesswerte zu bestimmen.

Bei einer bevorzugten Weiterbildung sind zwei Messelemente vorgesehen, wobei die beiden Messelemente Temperaturmesswiderstände sind, um die Vorrichtung beispielsweise in Wärmezählern einzusetzen.

Gegenstand der vorliegenden Erfindung ist somit auch ein Wärmezähler, der eine erfindungsgemäße Vorrichtung mit zwei Messelementen umfasst, wobei die Vorrichtung zur Digitalisierung wenigstens eines analogen Messwerts ausgelegt ist, die Umsetzung der von beiden Messelementen erfassten analogen Temperaturwerte in digitale Werte mittels dreier nacheinander ablaufender Diskretisierungsschritte durchzuführen, wobei in jedem Diskretisierungsschritt ein erstes Referenzpotential mittels einer ersten Ausgangsinformation und ein zweites Referenzpotential mittels einer anderen als der ersten Ausgangsinformation bestimmt wird, wobei in allen drei Diskretisierungsschritten das erste Referenzpotential auf derselben Ausgangsinformation und das zweite Referenzpotential auf jeweils unterschiedlichen Ausgangsinformationen beruhen, und wobei die Zählvorrichtung geeignet ist, in jedem Diskretisierungsschritt einer Differenz gebildet aus dem ersten Referenzpotential und dem zweiten Referenzpotential einen Zählwert zuzuordnen.

Weiterhin wird die Aufgabe gelöst durch ein Verfahren zur Digitalisierung von wenigstens einem analogen Messwert mittels einer Vorrichtung umfassend eine Messschaltung mit einem Messelement, einem ersten Referenzelement und einem zweiten Referenzelement, die in Serie angeordnet sind, wobei die Messschaltung wenigstens drei Ausgänge aufweist, an denen analoge Ausgangsinformationen in Form von Ausgangspotentialen abgegriffen werden können, einen Multiplexer, der mit den wenigstens drei Ausgängen einzeln und nacheinander verbindbar ist, einen Spannungsrampengenerator, ein erstes Vergleichselement, das am seinem ersten Eingang unter Zwischenschaltung des Multiplexers mit der Messschaltung und an seinem zweiten Eingang mit dem Spannungsrampengenerator verbunden ist, eine Zählvorrichtung mit wenigstens zwei Zählern, eine Steuervorrichtung und eine Recheneinheit, gekennzeichnet durch folgende Schritte:

a. Bestimmen eines ersten Referenzpotentials aus einer ersten Ausgangsinformation,
b. Auswählen einer zweiten Ausgangsinformation, die sich von der ersten Ausgangsinformation unterscheidet,
c. Erzeugen einer Rampenspannung,
d. Auslösen eines Zählvorgangs in der Zählvorrichtung, wenn die Rampenspannung das erste Referenzpotential erreicht hat,
e. Beenden des Zählvorgangs, wenn die Rampenspannung den Potentialwert der ausgewählten Ausgangsinformation erreicht hat, und Zuordnen des Zählwerts zu einem Zähler der Zählvorrichtung,
f. Löschen der Spannungsrampe,
g. Wiederholen der Schritte a) bis f) mit einer dritten Ausgangsinformation, die sich von der ersten und zweiten Ausgangsinformation unterscheidet,
h. Bestimmen des Messwerts des Messelements (RM_V, RM_R) mittels der ermittelten Zählwerte.

Das erfindungsgemäße Verfahren greift auf das Single-Slope-Verfahren zurück und hat den Vorteil gegenüber bisher bekannten Verfahren, dass es kostengünstig arbeitet, einen niedrigen Stromverbrauch hat, die Umwandlung vergleichsweise schnell erfolgt und vor allem zu digitalen Messwerten führt, die eine vergleichsweise hohe Messgenauigkeit und Messstabilität aufweisen.

Die hohe Messgenauigkeit und Messstabilität ist vor allem darauf zurückzuführen, dass bei dem gesamten Umwandlungsverfahren das gleiche Referenzpotential verwendet wird.

Bei dem erfindungsgemäßen Verfahren ist es von Vorteil, dass das Messelement und das erste Referenzelement ein Messwiderstand ist.

Bei einer bevorzugten Weiterbildung des erfindungsgemäßen Verfahrens überquert die Rampenspannung vor jedem Zählvorgang das erste Referenzpotential mit gegenüber dem Zählvorgang geänderten Vorzeichen und ändert nach einer vorgegebenen Zeitdauer das Vorzeichen, um mit dem für den Zählvorgang notwendigen Vorzeichen das erste Referenzpotential zu passieren. Hierdurch wird sichergestellt, dass der Zählvorgang auch bei Schwankungen des Referenzpotentials ausgelöst wird.

Hierbei ist es von Vorteil, dass die Zeitdauer für die Änderung des Vorzeichens der Rampenspannung von einem Zeitzählelement vorgegeben wird, wobei das Zeitzählelement ausgelöst wird, wenn die Rampenspannung bei gegenüber dem Zählvorgang geändertem Vorzeichen das erste Referenzpotential passiert. Mit Hilfe des Zeitzählelements kann die optimale Zeitdauer in Hinblick auf Geschwindigkeit und Sicherheit der Umwandlung der Analogdaten in Digitaldaten festgelegt werden.

Zur Anwendung des Verfahren in einem Wärmezähler ist es von Vorteil, dass ein erstes Messelement, ein zweites Messelement, ein erstes Referenzelement und ein zweites Referenzelement vorgesehen sind, die in Serie geschalten sind, wobei das erste Messelement und das zweite Messelement als Temperaturmesswiderstände ausgebildet sind, und dass mindestens vier analoge Ausgangsinformationen in Form von Ausgangspotentialen zur Verfügung stehen, wobei die Schritte a) bis f) auch für die vierte analoge Ausgangsinformation durchgeführt werden, wobei jeder erhaltene Zählwert einem eigenen Zähler zugeordnet wird und wobei die an den Temperaturmesswiderständen anliegenden Temperaturen mittels der ermittelten Zählwerte bestimmt werden.

Aus den ermittelten Zählwerten lassen sich folglich auch Temperaturdifferenzen in Wärmezählern bestimmen.

Bevorzugte Ausführungsformen werden anhand der beigefügten Zeichnungen näher erläutert, in denen zeigen:

Fig. 1     ein Blockschaltbild der erfindungsgemäßen Vorrichtung;

Fig. 2    den Messvorgang in graphischer Darstellung;

Fig. 3    einen Ausschnitt aus dem Messverfahren gemäß Fig. 2;

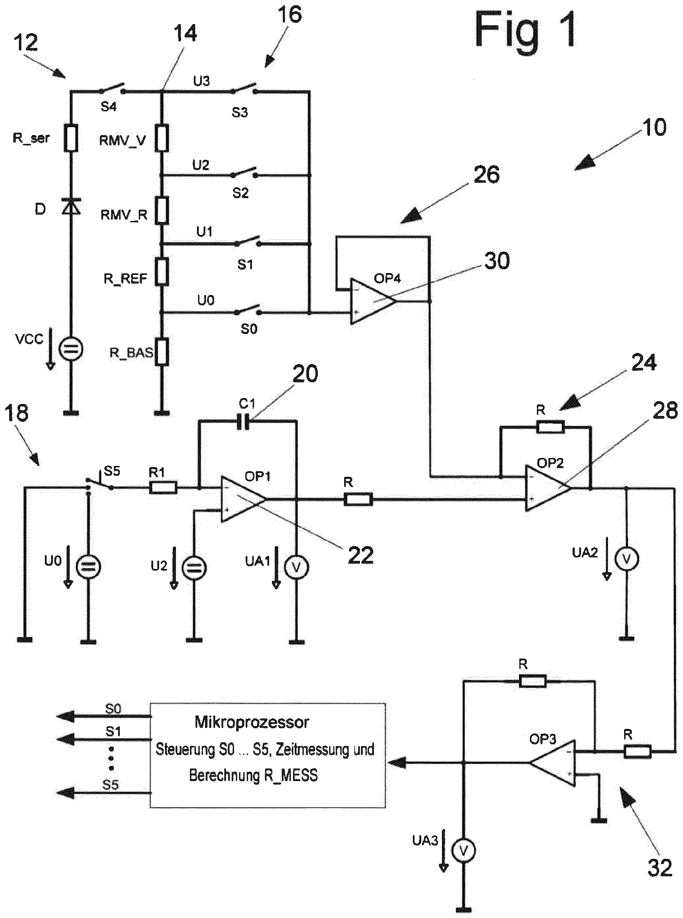

Fig. 1 zeigt ein Blockschaltbild einer Vorrichtung zum Digitalisieren von wenigstens einem analogen Messwert 10. Die Vorrichtung zur Digitalisierung von wenigstens einem analogen Messwert 10 umfasst eine Messschaltung 12 mit zwei in Serie angeordneten Messelementen RM_V und RM_R sowie ein ebenfalls in Serie angeordnetes erstes Referenzelement R_Bas und ein zweites Referenzelement R_Ref. Die Messelemente RM_V, RM_R das zweite Referenzelement R_Ref und das erste Referenzelement R_Bas sind in der genannten Reihenfolge mit einer Energiequelle verbunden, wobei das Messelement RM_V der Energiequelle am nächsten liegt. Weiterhin ist ein Schalter S4 vorgesehen, der den Strom der Messschaltung 12 ein- und ausschaltet.

Vor und nach jedem Messelement RM_V, RM_R sowie Referenzelement R_Ref sind Knotenpunkte bzw. Ausgänge 14 vorhanden, an denen Ausgangsinformationen in Form von Spannungswerten abgegriffen werden können. Die Ausgänge 14 sind mit den Eingängen eines Multiplexers 16 verbunden, von dem im Wesentlichen die einzelnen Schalter S0, S1, S2 und S3 dargestellt sind. Mittels des Multiplexers 16 können die Ausgänge 14 einzeln und nacheinander mit den dem Multiplexer 16 nachgeordneten Elementen verbunden werden.

An den Ausgängen 14 liegen jeweils die Spannungswerte U0, U1, U2 und U3 an, wobei der Spannungswert U0 nach dem Referenzelement R_Ref abgegriffen wird. Die Spannung U1 liegt nach dem Messelement RM_R an, die Spannung U2 kann nach dem Messelemente RM_V abgegriffen werden und die Spannung U3 wird vor dem Messelemente RM_V erfasst. Die räumlichen Angaben beziehen sich hierbei auf die Stromflussrichtung in der Messschaltung.

Weiterhin umfasst die Vorrichtung zum Digitalisieren von wenigstens einem analogen Messwert 10 einen Spannungsrampengenerator 18.

Der Spannungsrampengenerator 18 umfasst einen Integrator 20, einen dem Integrator 20 parallel geschalteten Kondensator 22 sowie einen Schalter S5.

Der Ausgang des Spannungsrampengenerators 18 und der Ausgang des Multiplexers 16 gelangen in den Eingang eines ersten Vergleichselements 24. Zwischen dem Ausgang des Multiplexers 16 und dem Eingang des ersten Vergleichselements 24 ist ein Impedanzwandler 26 vorgesehen.

Der Impedanzwandler 26 ist vorgesehen, um eventuell auftretende Messfehler weiter zu reduzieren.

Sowohl das erste Vergleichselement 24 als auch der Impedanzwandler 26 umfassen einen Komparator 28 bzw. Komparator 30.

Der Komparator 28 des ersten Vergleichselements 24 vergleicht die Ausgangsspannung des Spannungsrampengenerators 18 mit den Spannungen U0, U1, U2, U3, die sich abhängig von der Stellung der Schalter S0, S1, S2 und S3 ergeben.

Schließlich sind ein Verstärker 32 und ein Mikroprozessor 34 mit einer Zählvorrichtung, einer Steuervorrichtung und einer Recheneinheit vorgesehen.

Mit Hilfe einer solchen Vorrichtung zum Digitalisieren von wenigstens einem analogen Messwert 10 lässt sich beispielsweise die Temperaturdifferenz zweier Messfühler in einem Wärmezähler bestimmen.

Bei einem Wärmezähler entspricht der Widerstand RM_V einem Temperaturfühler im Vorlauf und der Widerstand RM_R dem Temperaturfühler im Rücklauf. Der Referenzwiderstand des Referenzelements R_Ref ist vorgegeben und bekannt.

Der Widerstand des ersten Referenzelements R_Bas dimensioniert U0 und ist bevorzugt so zu wählen, dass der Messstrom möglichst minimal wird und der Wert des Widerstands konstant für die Dauer eines Messvorgangs ist.

Im Detail wird nun ein Messvorgang zur Bestimmung einer Temperaturdifferenz beispielsweise zwischen einer Vorlaufleitung und einer Rücklaufleitung in einem Heizsystem mittels der in Fig. 1 dargestellten Vorrichtung zum Digitalisieren von wenigstens einem analogen Messwert 10 beschrieben.

Der eigentliche Messvorgang wird durch Umlegen des Schalters S4 in der Messschaltung 12 gestartet. In dem Multiplexer 16 wird der Schalter S0, der mit dem Ausgang des Referenzwiderstands R_Ref verbunden ist, umgelegt. Die Schalter S1, S2 und S3 bleiben geöffnet. An dem Komparator 28 des ersten Vergleichselements 24 liegt somit das Referenzpotential U0 an.

Um die Rampenspannung des Spannungsrampengenerators 18 zu initiieren, wird in dem Spannungsrampengenerator 18 der zuvor aufgeladene Kondensator 22 des Spannungsrampengenerators 18 entladen und erzeugt eine Spannungsrampe mit negativem Vorzeichen, wobei der Spannungswert der Spannungsrampe am Anfang der Spannungsrampe über dem Referenzpotential U0 liegt.

Die Situation, bei der das Ausgangssignal des Komparators 26 gleich groß ist, entspricht einem Schaltpunkt Cn, bei dem ein Zählvorgang in einem nicht dargestellten Zähler ZZ ausgelöst wird. Erreicht der Zähler ZZ eine vorgegebene Zeitdauer $t_{ZZ}1$, schaltet der Schalter S5 des Spannungsrampengenerators 18 und gibt den Startzeitpunkt zur Erzeugung einer Spannungsrampe mit positiven Vorzeichen.

Erreicht die Spannungsrampe zu einem Zeitpunkt t01 den Wert des Referenzpotentials U0, kippt der Komparator 26 und startet den Zählvorgang eines Zählers C1 der Zählvorrichtung.

Um die zwischen den beiden Widerständen RM_V und RM_R anliegende Spannung U1 zu bestimmen, wird zeitgleich mit dem Start des Zählvorgangs zunächst der Schalter S0 der Messschaltung 12 geöffnet und der Schalter S1 geschlossenen. Die Schalter S2 und S3 bleiben geöffnet. Erreicht die Spannungsrampe im Zeitpunkt t1 das Potential von U1, kippt der Komparator 28 und stoppt den Zählvorgang des Zählers C1.

Dem Abschnitt der Rampenspannung A zwischen dem Zeitpunkten t01 und t1 wird ein Zählwert zugeordnet.

Nach dem Ende des Zählvorgangs zum Zeitpunkt t1, schaltet der Schalter S5, um einen Entladevorgang zu starten. Der Kondensator 22 des Spannungsrampengenerators 18 wird entladen und erzeugt eine Spannungsrampe mit negativen Vorzeichen, wobei der Spannungswert der Spannungsrampe am Anfang der Spannungsrampe über dem Referenzpotential U0 liegt. In dem Multiplexer 16 werden der Schalter S1 geöffnet und der Schalter S0 geschlossen.

Wenn die Spannungsrampe mit negativem Vorzeichen durch das Referenzpotential U0 hindurchgeht, kippt der Komparator 26 und startet den Zähler ZZ. Erreicht der Zähler ZZ die Zeitdauer $t_{ZZ}1$, wird der Schalter S5 des Spannungsrampengenerators 18 umgelegt und gibt damit den Startzeitpunkt zur Erzeugung der positiven Spannungsrampe.

Erreicht die Spannungsrampe zu einem Zeitpunkt t02 den Wert des Referenzpotentials U0, kippt der Komparator 26 und startet den Zählvorgang eines Zählers C2 der Zählvorrichtung.

Um die an dem Widerstand RM_V anliegende Spannung U2 zu bestimmen, wird zeitgleich mit dem Start des Zählvorgangs zunächst der Schalter S0 der Messschaltung 12 geöffnet und der Schalter S2 geschlossenen. Die Schalter S1 und S3 bleiben geöffnet. Erreicht die Spannungsrampe im Zeitpunkt t2 das Potential von U2, kippt der Komparator 28 und stoppt den Zählvorgang des Zählers C2.

Dem Abschnitt der Rampenspannung B zwischen den Zeitpunkten t02 und t2 wird ein Zählwert zugeordnet.

Nach dem Ende des Zählvorgangs zum Zeitpunkt t2, schaltet der Schalter S5, um einen Entladevorgang zu starten Der Kondensator 22 des Spannungsrampengenerators 18 wird entladen und erzeugt eine Spannungsrampe mit negativen Vorzeichen, wobei der Spannungswert der Spannungsrampe am Anfang der Spannungsrampe über dem Referenzpotential U0 liegt. In dem Multiplexer 16 werden der Schalter S2 geöffnet und der Schalter S0 geschlossen.

Wenn die Spannungsrampe mit negativem Vorzeichen durch das Referenzpotential U0 hindurchgeht, kippt der Komparator 26 und startet den Zähler ZZ. Erreicht der Zähler ZZ die Zeitdauer $t_{ZZ}1$, wird der Schalter S5 des Spannungsrampengenerators 18 umgelegt und gibt damit den Startzeitpunkt zur Erzeugung der positiven Spannungsrampe.

Erreicht die Spannungsrampe zu einem Zeitpunkt t03 den Wert des Referenzpotentials U0, kippt der Komparator 26 und startet den Zählvorgang eines Zählers C3 der Zählvorrichtung.

Um das vor dem Widerstand RM_V anliegende Potential U3 zu bestimmen, wird zeitgleich mit dem Start des Zählvorgangs zunächst der Schalter S0 der Messschaltung 12 geöffnet und der Schalter S3 geschlossenen. Die Schalter S1 und S2 bleiben geöffnet. Erreicht die Spannungsrampe im Zeitpunkt t3 das Potential von U3, kippt der Komparator 28 und stoppt den Zählvorgang des Zählers C3.

Dem Abschnitt der Rampenspannung C zwischen dem Zeitpunkten t03 und t3 wird ein Zählwert zugeordnet.

Zur Beendigung der Messung wird der Schalter S4 geöffnet.

Die in dem Verfahren beschriebenen Schaltvorgänge werden durch die im Mikroprozessor vorgesehene Steuervorrichtung durchgeführt.

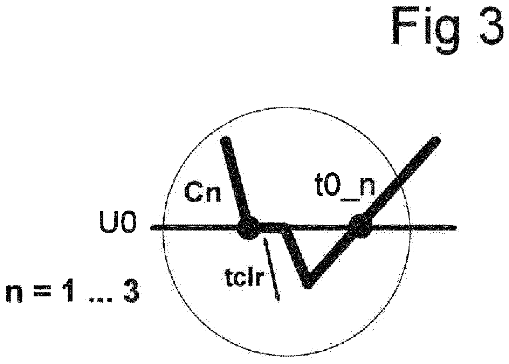

In Fig. 3 ist nochmals im Detail dargestellt, wie der Verlauf der Spannungsrampe beim Löschen und Starten des Zählvorgangs ausgebildet ist. Der Kondensator 22 des Spannungsrampengenerators 18 wird entladen, bis die Spannung des Spannungsrampengenerators 18 den Potentialwert U0 erreicht. Sobald der Potentialwert U0 erreicht wird, wird mittels der zweiten Vergleichsvorrichtung 26 ein Zählvorgang ausgelöst, um die Spannung der Spannungsrampe unter das Referenzpotential U0 zu führen. Nach einer vorgegebenen Zeitdauer wird der Zählvorgang beendet und der Spannungsrampengenerator 18 umgeschaltet, um eine positive Spannungsrampe zu erzeugen. Sobald die positive Spannungsrampe das Potential U0 erreicht hat, wird der eigentliche Zählvorgang ausgelöst.

Üblicherweise werden in den Zählvorrichtungen schwingende Oszillatoren verwendet, so dass bekanntermaßen Zählereignisse unmittelbar in Zeitereignisse übertragen werden können. Es spielt somit keine Rolle, ob Zählwerte oder Zeitwerte im Zusammenhang mit der Erfassung einer Zeitdauer angegeben werden.

Durch diese Maßnahme können eventuell auftretende Messfehler weiter reduziert werden.

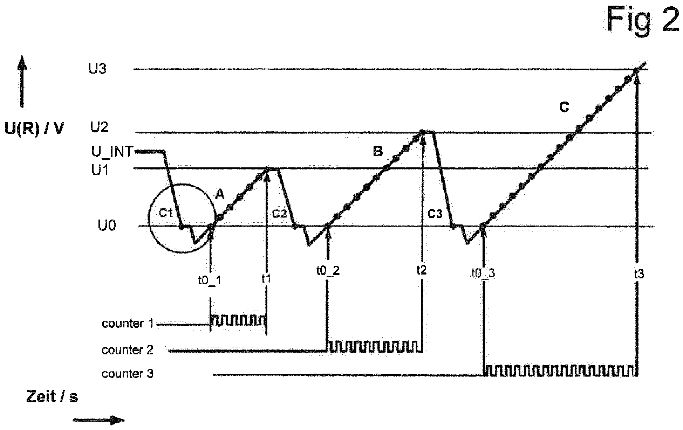

Wie Fig. 2 zu entnehmen ist, entstehen bei dem beschriebenen Verfahren drei Rampen A, B, C. Für jede dieser Rampen A, B, C ist ein Zählwert hinterlegt. Der Zählwert kann wie oben angegeben ein absolute Zahl oder eine Zeiteinheit sein.

Der in den Zählern hinterlegte Wert ist proportional zur Spannungsdifferenz der einzelnen Rampen.

Der Wert der Widerstände RM_V und RM_R kann somit gemäß folgender Formeln in der Recheneinheit des Mikroprozessors berechnet werden:

$$RM\_R = [(t2-t02) - (t1-t01)] / (t1-t01) \; x \; R\_Ref$$

$$RM\_V = [(t3-t03) - (t2-t02)] / (t1-t01) \; x \; R\_Ref$$

Der Zusammenhang zwischen Widerstand R und Temperatur T ist bekannt, nämlich:

$$R(T) = R_0 \; [1+AT+BT^2+C \; (T-100° \; C)T^3]. \; ,$$

mit $R_0$, A, B, C vorgegebene Materialkonstanten.

Bei Temperaturen von 0°C bis 850°C kann mit folgender Näherung gerechnet werden:

$$R(T) = R_0 \; [1+AT+BT^2].$$

Aus dem oben genannten Zusammenhang zwischen Widerstand und Temperatur kann der absolute Messwert an den beiden Messwiderständen berechnet werden.

Die in Fig. 1 dargestellte Vorrichtung zum Digitalisieren von wenigstens einem analogen Messwert ist für den Einsatz in Wärmezählern geeignet, bei dem eine Temperaturdifferenz bestimmt werden muss.

Bei einer nicht dargestellten Ausführungsform einer Vorrichtung zum Digitalisieren von wenigstens einem analogen Messwert kann ein Messelement weggelassen werden, um nur den vom Messwert erfassten Wert zu digitalisieren. Handelt es sich bei dem Messelement um einen Messwiderstand, kann diese Vorrichtung dazu verwendet werden, um einen Temperaturwert digital zu erfassen.

**Patentansprüche**

1. Vorrichtung zur Digitalisierung von wenigstens einem analogen Messwert, umfassend
eine Messschaltung (12) mit einem Messelement (RM_V, RM_R), einem ersten Referenzelement (R_Bas) und einem zweiten Referenzelement (R_Ref), die in Serie angeordnet sind, wobei die Messschaltung (12) wenigstens drei Ausgänge (14) aufweist, an denen analoge Ausgangsinformationen in Form von Ausgangspotentialen abgegriffen werden können,
einen Multiplexer (16), der einzeln und nacheinander mit den wenigstens drei Ausgängen (14) verbindbar ist,
einen Spannungsrampengenerator (18),
ein erstes Vergleichselement (24), das an seinem ersten Eingang unter Zwischenschaltung des Multiplexers (16) mit der Messschaltung (12) und an seinem zweiten Eingang mit dem Spannungsrampengenerator (18) verbunden ist,
eine Zählvorrichtung mit wenigstens zwei Zählern,
eine Steuervorrichtung und,
eine Recheneinheit
**dadurch gekennzeichnet, dass** die Vorrichtung zur Digitalisierung eines analogen Messwerts ausgelegt ist, die Umsetzung des analogen Messwert in einen digitalen Messwert mittels zweier nacheinander ablaufender Diskretisierungsschritte durchzuführen, wobei in jedem Diskretisierungsschritt ein erstes Referenzpotential mittels einer ersten Ausgangsinformation und ein zweites Referenzpotential mittels einer anderen als der ersten Ausgangsinformation bestimmt wird, wobei in beiden Diskretisierungsschritten das erste Referenzpotential auf derselben Ausgangsinformation und das zweite Referenzpotential auf unterschiedlichen Ausgangsinformationen basieren, und wobei die Zählvorrichtung geeignet ist, in jedem Diskretisierungsschritt einer Differenz gebildet aus dem ersten Referenzpotential und dem zweiten Referenzpotential einen Zählwert zuzuordnen.

2. Vorrichtung nach Anspruch 1, **dadurch gekennzeichnet, dass** das Messelement (RM_V, RM_R) und das zweite Referenzelement (R_Ref) in Stromflussrichtung der Messschaltung (12) vor dem ersten Referenzelement (R_Bas) angeordnet ist und sich die wenigstens drei Ausgänge (14) der Messschaltung (12) in Stromflussrichtung der Messschaltung (12) vor und hinter dem Messelement (RM_V, RM_R) und vor und hinter dem zweiten Referenzelement (R_Ref) befinden.

3. Vorrichtung nach Anspruch 1 oder 2, **dadurch gekennzeichnet, dass** ein Impedanzwandler (26) vorgesehen ist, wobei der Impedanzwandler (26) zwischen dem Ausgang des Multiplexers (16) und dem ersten Eingang des ersten Vergleichselements (14) angeordnet ist.

4. Vorrichtung nach einem der vorhergehenden Ansprüche, **dadurch gekennzeichnet, dass** ein Zeitzählelement vorgesehen ist.

5. Vorrichtung nach einem der vorhergehenden Ansprüche, **dadurch gekennzeichnet, dass** das Messelement (RM_V, RM_R) und das Referenzelement (R_Ref) jeweils ein Messwiderstand ist.

6. Vorrichtung nach einem der vorhergehenden Ansprüche, **dadurch gekennzeichnet, dass** zwei Messelemente (RM_V, RM_R) vorgesehen sind, wobei die beiden Messelemente (RM_V, RM_R) Temperturmesswiderstände sind.

7. Wärmezähler umfassend eine Vorrichtung nach Anspruch 6, **dadurch gekennzeichnet, dass** die Vorrichtung zur Digitalisierung wenigstens eines analogen Messwerts ausgelegt ist, die Umsetzung der von beiden Messelementen (RM_V, RM_R) erfassten analogen Temperaturwerte in digitale Werte mittels dreier nacheinander ablaufender Diskretisierungsschritte durchzuführen, wobei in jedem Diskretisierungsschritt ein erstes Referenzpotential mittels einer ersten Ausgangsinformation und ein zweites Referenzpotential mittels einer anderen als der ersten Ausgangsinformation bestimmt wird, wobei in allen drei Diskretisierungsschritten das erste Referenzpotential auf derselben Ausgangsinformation und das zweite Referenzpotential auf jeweils unterschiedlichen Ausgangsinformationen beruhen, und wobei die Zählvorrichtung geeignet ist, in jedem Diskretisierungsschritt einer Differenz gebildet aus dem ersten Referenzpotential und dem zweiten Referenzpotential einen Zählwert zuzuordnen.

8. Verfahren zur Digitalisierung von wenigstens einem analogen Messwert mittels einer Vorrichtung, umfassend eine Messschaltung (12) mit einem Messelement (RM_V, RM_R), einem ersten Referenzelement (R_Bas) und einem zweiten Referenzelement (R_REF), die in Serie angeordnet sind, wobei die Messschaltung (12) wenigstens drei Ausgänge (14) aufweist, an denen analoge Ausgangsinformationen in Form von Ausgangspotentialen abgegriffen werden können, einen Multiplexer (16), der mit den wenigstens drei Ausgängen (14) einzeln und nacheinander verbindbar ist, einen Spannungsrampengenerator (18), ein erstes Vergleichselement (24), das am seinem ersten Eingang unter Zwischenschaltung des Multiplexers (16) mit der Messschaltung (12) und an seinem zweiten Eingang mit dem Spannungsrampengenerator (18) verbunden ist, eine Zählvorrichtung mit wenigstens zwei Zählern, eine Steuervorrichtung und eine Recheneinheit, **gekennzeichnet durch** folgende Schritte:

   a. Bestimmen eines ersten Referenzpotentials aus einer ersten Ausgangsinformation,
   b. Auswählen einer zweiten Ausgangsinformation, die sich von der ersten Ausgangsinformation unterscheidet,
   c. Erzeugen einer Rampenspannung,
   d. Auslösen eines Zählvorgangs in der Zählvorrichtung, wenn die Rampenspannung das erste Referenzpotential erreicht hat,
   e. Beenden des Zählvorgangs, wenn die Rampenspannung den Potentialwert der ausgewählten Ausgangsinformation erreicht hat, und Zuordnen des Zählwerts zu einem Zähler der Zählvorrichtung,
   f. Löschen der Spannungsrampe,
   g. Wiederholen der Schritte a) bis f) mit einer dritten Ausgangsinformation, die sich von der ersten und zweiten Ausgangsinformation unterscheidet.
   h. Bestimmen des Messwerts des Messelements (RM_V, RM_R) mittels der ermittelten Zählwerte.

9. Verfahren nach Anspruch 8, **dadurch gekennzeichnet, dass** das Messelement (RM_V, RM_R) und das zweite Referenzelement (R_REF) ein Messwiderstand sind.

10. Verfahren nach Anspruch 8 oder 9, **dadurch gekennzeichnet, dass** vor jedem Zählvorgang die Rampenspannung mit gegenüber dem Zählvorgang geänderten Vorzeichen das erste Referenzpotential überquert und nach einer vorgegebenen Zeitdauer die Rampenspannung das Vorzeichen ändert und mit dem für den Zählvorgang notwendigen Vorzeichen das erste Referenzpotential passiert.

11. Verfahren nach Anspruch 10, **dadurch gekennzeichnet, dass** die Zeitdauer für die Änderung des Vorzeichens der Rampenspannung von einem Zeitzählelement vorgegeben wird, wobei der Zeitzählelement ausgelöst wird, wenn die Rampenspannung bei gegenüber dem Zählvorgang geänderten Vorzeichen das erste Referenzpotential passiert.

12. Verfahren nach einem der Ansprüche 8 bis 11, **dadurch gekennzeichnet, dass** ein erstes Messelement (RM_V), ein zweites Messelement (RM_R), ein erstes Referenzelement (R_Bas) und ein zweites Referenzelement (R_Ref) vorgesehen sind, die in Serie angeordnet sind, wobei das erste Messelement (RM_V) und das zweite Messelement (RM_R) als Temperaturmesswiderstände ausgebildet sind, und dss mindestens vier analoge Ausgangsinformationen in Form von Ausgangspotentialen zur Verfügung stehen, wobei die Schritte a) bis f) auch für die vierte analoge Ausgangsinformation durchgeführt werden, wobei jeder erhaltene Zählwert einem eigenen Zähler zugeordnet wird und wobei die an den Temperaturmesswiderständen anliegenden Temperaturen mittels der ermittelten Zählwerte bestimmt werden.

# Fig 1

Fig 2

Fig 3

Cn

t0_n

U0

tclr

n = 1 ... 3

**Europäisches Patentamt**

**European Patent Office**

**Office européen des brevets**

# EUROPÄISCHER RECHERCHENBERICHT

Nummer der Anmeldung

EP 17 19 1749

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | DE 32 00 353 A1 (GERABERG THERMOMETER [DD]) 9. Dezember 1982 (1982-12-09) * Seiten 3,6; Abbildung 1 * ----- | 1-12 | INV. H03M1/56 |
| X,D | EP 1 630 533 B1 (ACTARIS SAS [FR]) 5. Oktober 2011 (2011-10-05) * Ansprüche 1-10; Abbildung 2 * ----- | 1-12 | |

RECHERCHIERTE SACHGEBIETE (IPC)

H03M

Der vorliegende Recherchenbericht wurde für alle Patentansprüche erstellt

| Recherchenort | Abschlußdatum der Recherche | Prüfer |
|---|---|---|
| Den Haag | 27. Februar 2018 | Jesus, Paulo |

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 17 19 1749

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-02-2018

| Im Recherchenbericht angeführtes Patentdokument | Datum der Veröffentlichung | Mitglied(er) der Patentfamilie | Datum der Veröffentlichung |
|---|---|---|---|
| DE 3200353 A1 | 09-12-1982 | DD 206176 A3<br>DE 3200353 A1 | 18-01-1984<br>09-12-1982 |
| EP 1630533 B1 | 05-10-2011 | AT 527528 T<br>EP 1630533 A1<br>FR 2874692 A1 | 15-10-2011<br>01-03-2006<br>03-03-2006 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1630533 B1
- DE 3200353 A1